# EUROPÄISCHE PATENTSCHRIFT

(11) **EP 3 120 459 B1**
(45) Veröffentlichungstag und Bekanntmachung des Hinweises auf die Patenterteilung: **15.04.2020**
(21) Anmeldenummer: 15711704.5
(22) Anmeldetag: 16.03.2015
(51) Int. Cl.: H03K 17/96

(54) **ELEKTRONISCHES GERÄT UND BEDIENANORDNUNG MIT EINEM ELEKTRONISCHEN GERÄT**
ELECTRONIC DEVICE AND OPERATING ASSEMBLY HAVING AN ELECTRONIC DEVICE
APPAREIL ÉLECTRONIQUE ET SYSTÈME DE COMMANDE COMPRENANT UN APPAREIL ÉLECTRONIQUE

(30) Priorität: 18.03.2014 DE 102014003864
(43) Veröffentlichungstag der Anmeldung: 25.01.2017
(73) Patentinhaber: Leopold Kostal GmbH & Co. KG, 58513 Lüdenscheid (DE); Bayerische Motoren Werke Aktiengesellschaft, 80809 München (DE)
(72) Erfinder: MOLKOW, Peter, 44265 Dortmund (DE); TENBRÜGGEN, Karl Wilhelm, 46286 Dorsten (DE); BRENDEL, Markus, 44625 Herne (DE); HUPERZ, Guido, 57462 Olpe (DE); BLECKMANN, Michael, 58239 Schwerte (DE); MIEDL, Florian, 80803 München (DE); TILLE, Thomas, 81249 München (DE)
(74) Vertreter: Kerkmann, Detlef
(86) Internationale Anmeldenummer: PCT/EP2015/055458
(87) Internationale Veröffentlichungsnummer: WO 2015/140115

(56) Entgegenhaltungen:
- EP-A2- 1 672 797
- DE-A1-102006 039 133
- GB-A- 2 426 344
- US-A- 5 917 165
- US-B1- 7 576 631

## Beschreibung

Die Erfindung betrifft ein elektronisches Gerät mit einem Gehäuse und mit einer mit dem Gehäuse elektrisch verbundenen Leiterfolie, wobei die Leiterfolie einen Funktionsabschnitt aufweist, der sich außerhalb des Gehäuses befindet, und der Sensoren und/oder Anzeigeelemente trägt und zur Montage an der Rückseite einer Bedienblende vorgesehen ist. Die Erfindung betrifft zudem eine Bedienanordnung mit einem elektronischen Gerät.

Bedienanordnungen von Kraftfahrzeugen oder auch von elektrischen Haushaltsgeräten weisen oftmals Bedienblenden mit Anzeige- und Schaltelementen auf. Bei modernen Bedienblenden sind Schaltelemente vielfach als kontaktlose kapazitive Berührungssensoren ausgeführt, welche Leiterflächen aufweisen, die an der Rückseite einer ebenen Bedienblende angeordnet sind.

Für ein schlüsselloses Zugangssystem für ein Kraftfahrzeug ist ein gattungsgemäßes elektronisches Gerät bereits in dem Patentdokument US 7 576 631 B1 offenbart.

Aus der deutschen Offenlegungsschrift DE 10 2006 039 133 A1 ist eine Bedieneinrichtung mit mindestens einer kapazitiven Sensortaste bekannt. Die Sensortaste ist ein elektrisch leitfähiges Sensorelement mit einer Sensorfläche, die an der Rückseite einer elektrisch isolierenden Abdeckplatte anliegt. In einem Abstand von der Abdeckplatte ist eine Leiterplatte angeordnet. Das Sensorelement erstreckt sich von der Abdeckplatte bis zu der Leiterplatte, wobei zwischen der Abdeckplatte und der Leiterplatte ein Lichtkasten angeordnet ist, durch den das Sensorelement in einer vorgegebenen Position an der Rückseite der Abdeckplatte parallel und senkrecht zur Abdeckplatte fixiert ist.

Die in diesem Dokument beschriebene Bedieneinrichtung ist insbesondere ein Teil eines Haushaltsgeräts, wie etwa einer Wasch- oder Spülmaschine. Bei einem derartigen Gerät ist es im Allgemeinen unproblematisch oder sogar zweckmäßig, eine Bedieneinrichtung mit einer integrierten Elektronik herzustellen und dazu den die Elektronik tragenden Schaltungsträger mit einer Bedienblende mechanisch zu verbinden.

Problematischer sind Geräte, bei denen eine elektronische Einrichtung in einem Modulgehäuse vormontiert ist und darüber hinaus Sensoren und/oder Anzeigeelemente an einer dazu separaten Bedienblende, beispielsweise dem Armaturenbrett eines Kraftfahrzeugs, anzubringen sind.

Prinzipiell können flexible Schaltungsträger, wie etwa Leiterfolien, vorgesehen werden, um Sensoren und/oder Anzeigeelemente an der Rückseite einer Bedienblende zu montieren. In bekannten Anwendungsfällen werden Leiterfolien, die kapazitive Sensorflächen als flächige Leiterbahnabschnitte tragen, direkt hinter eine Bedienblende geklebt oder durch eine Umspritzung befestigt. Die Sensorflächen oder Anzeigeelemente müssen dann kontaktiert und mit einer zugeordneten Auswerteelektronik verbunden werden. Dadurch ergibt sich, besonders bei einem begrenzten Bauraum, eine oft schwierige Montage. Zudem ist es erst nach der Endmontage möglich, eine Prüfung der gesamten Funktionalität durchzuführen. Nachteilig ist auch, dass eine solche Anordnung im Bedarfsfall schwierig zu demontieren ist.

Sensorflächen auf einer Leiterfolie können prinzipiell auch durch mechanisches Andrücken, etwa durch ein federnd befestigtes Gehäuse, an einer Bedienblende befestigt werden, wodurch die aufwendige Fixierung durch Kleben oder Umspritzen entfällt. Hierbei ist problematisch, dass Bedienblenden und insbesondere die Rückseiten von Armaturenbrettern vielfach Wölbungen oder Unebenheiten aufweisen, so dass es schwierig ist, den Funktionsabschnitt einer relativ breiten flexiblen Leiterfolie gleichmäßig an die Bedienblende anzupressen. Liegen speziell die Sensoren tragenden Bereiche der Leiterfolie nicht dicht an der Bedienblende an, so kann hierdurch die Funktion der Sensoren beeinträchtigt werden. Besonders die Empfindlichkeit und Funktionssicherheit kapazitiver Sensoren kann, aufgrund der im Vergleich zu Kunststoff sehr geringen relativen Permittivität von Luft, durch Lufteinschüsse zwischen den Sensorelementen und der Bedienblende erheblich vermindert werden.

Auch für mehrteilige oder flächige Anzeigeelemente, die an der Rückseite einer transparenten oder teiltransparenten Bedienblende angeordnet sind, ist es vorteilhaft, wenn diese einen möglichst geringen und gleichmäßigen Abstand zur Rückseite der Bedienblende einhalten, um eine störende ungleichmäßige Helligkeitsverteilungen oder eine bereichsweise undeutliche Darstellung zu vermeiden.

Es stellte sich die Aufgabe, ein elektronisches Gerät zu schaffen, das es ermöglicht, eine mit einem Gehäuse des verbundene Leiterfolie auf kostengünstige und montagetechnisch einfache Weise spaltfrei auch an eine nicht vollständig ebene Bedienblende anzufügen.

Diese Aufgabe wird erfindungsgemäß dadurch gelöst, dass zwischen einer Außenseite des Gehäuses und der Rückseite des Funktionsabschnitts der Leiterfolie ein Elastomerkörper und eine Leiste aus einem nichtelastomeren Kunststoff angeordnet sind, dass die Außenseite des Gehäuses und die Hauptflächen des Elastomerkörpers und der Leiste im Wesentlichen parallel zueinander angeordnet sind, und dass die mit dem Gehäuse verbundene Leiste den Elastomerkörper klemmend oder formschlüssig am Gehäuse befestigt.

Die erfindungsgemäße Ausgestaltung des Geräts sorgt für eine Formanpassung zwischen der Leiterfolie und der Bedienblende. Dadurch ist gewährleistet, dass weitgehend unabhängig von der Oberflächenqualität der Bedienblende die Folie gleichmäßig mit geringem Abstand an die Bedienblende angedrückt wird. Mit dieser Erfindung wird insbesondere erreicht, dass das elektronische Gerät auch an einer unebenen Bedienblende sicher funktioniert und damit vor der Befestigung an der Bedienblende vormontiert und geprüft werden kann.

Besonders vorteilhaft ist es, wenn die Leiste durch mehrere in ihrer Querrichtung eingebrachte Einschnitte eine kammartige Struktur aufweist. Hierdurch kann die aus Leiste und angefügter Leiterfolie bestehende Anordnung zugleich sowohl stabil als auch torsions- und biegeweich gestaltet werden. Dieses wiederum unterstützt ein enges Anfügen der Leiterfolie an die Bedienblende.

Vorteilhaft ist es zudem, die Leiste aus einem transparenten Material zu fertigen und den Elastomerkörper mit einer Anordnung von Ausnehmungen zu versehen. Hierdurch können innerhalb des Gehäuses Leuchtmittel eingesetzt werden, welche Sensorfelder oder Anzeigelemente auf der Leiterfolie durchleuchten oder hinterleuchten und so durch eine transparente oder teiltransparente Bedienblende hindurch sichtbar machen. Die Ausnehmungen in dem Elastomerkörper können vorteilhafterweise wabenförmig ausgebildet sein.

In Folgenden soll das Funktionsprinzip und ein Ausführungsbeispiel der Erfindung anhand der Zeichnung dargestellt und näher erläutert. Es zeigen
- Figur 1: ein elektronisches Gerät,
- Figur 2: eine Explosionsansicht einer Bedienanordnung mit einem elektronischen Gerät.

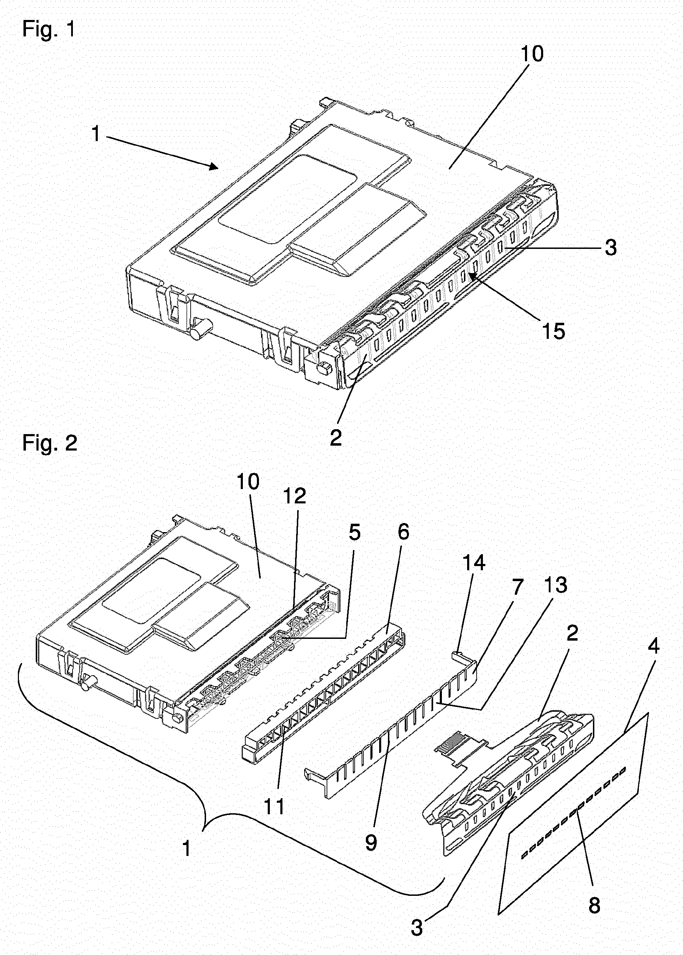

Die Figur 1 zeigt eine Außenansicht eines erfindungsgemäßen elektronischen Geräts 1. Im dargestellten Zustand ist das Gerät 1 fertig vormontiert, aber noch nicht Bestandteil einer Bedienanordnung. Das Gerät 1 besteht aus einem kastenartigen Gehäuse 10, welches im Inneren eine hier nicht dargestellte Anordnung elektronischer Bauteile enthält. Das Gerät 1 weist eine flexible Leiterfolie 2 auf, die mit der im Inneren des Gehäuses 10 befindlichen Elektronik verbunden ist. Eine Teilfläche 3 dieser Leiterfolie 2 ist entlang einer Außenseite 5 des Gehäuses 10 angeordnet und bildet hier eine Stirnfläche 15 des Geräts 1 aus. Die Teilfläche 3 der Leiterfolie 2 ist zumindest abschnittsweise mit elektronischen Funktionselementen wie Sensoren und/oder Anzeigelementen belegt und wird daher im Folgenden kurz als Funktionsabschnitt 3 bezeichnet.

Der Funktionsabschnitt 3 ist dazu vorgesehen, an der Rückseite einer Bedienblende 4 angeordnet zu werden, wodurch die in der Figur 2 dargestellte Bedienanordnung entsteht. Die Explosionsdarstellung der Figur 2 macht zudem weitere Details des elektronischen Geräts 1 erkennbar.

Die Bedienblende 4, die hier vereinfachend als eine senkrecht stehende Fläche angedeutet ist, kann beispielsweise Bestandteil eines Haushaltsgeräts oder auch ein Teilabschnitt des Armaturenbretts eines Kraftfahrzeugs sein. Die Bedienanordnung entsteht durch die mechanische Anbindung des in der Figur 1 dargestellten elektronischen Geräts 1 an die Bedienblende 4, wobei die vom Gehäuse 10 abgewandte Vorderseite des Funktionsabschnitts 3 der Leiterfolie 2 an die Rückseite der Bedienblende 4 angekoppelt wird. Die Ankopplung geschieht durch Andrücken der Stirnfläche 15 des Geräts 1 an die Rückseite der Bedienblende 4, was beispielsweise dadurch erfolgen kann, dass hier nicht dargestellte Federelemente das Gerät 1 an die Bedienblende 4 anpressen.

Für eine einwandfreie Funktion ist es erforderlich, dass der Funktionsabschnitt 3 der Leiterfolie 2 gleichmäßig eng und frei von Zwischenräumen an der Bedienblende 4 anliegt. Besonders wichtig ist dies, wenn der Funktionsabschnitt 3 kapazitive Sensoren trägt, die durch manuelles Berühren funktionaler Berührflächen 8 auf der Vorderseite der Bedienblende 4 als Schaltelemente betätigbar sein sollen.

Problematisch ist, dass die Oberflächen von Bedienblenden, entweder bedingt durch die Erfordernisse des Anbauorts oder auch aufgrund von Bauteiletoleranzen, oftmals nicht vollständig eben ausgebildet sind. Das zwischenraumfreie Anfügen eines großflächigen Funktionsabschnitts durch einfaches Anpressen ist dadurch nicht ohne weiteres möglich. Dies gilt besonders dann, wenn, wie im Ausführungsbeispiel dargestellt, der anzufügenden Funktionsabschnitt zwar schmal, aber dafür relativ lang ausgebildet ist.

Ein zwischenraumfreies Anfügen setzte bisher die Verwendung von besonderen mechanischen Befestigungsmitteln voraus oder eine Befestigung des Funktionsabschnitts durch Ankleben. In jedem Fall erfordert der Ausgleich von Unebenheiten der Bedienblende einen erhöhten Montageaufwand. Im Fall des Anklebens ist zudem eine eventuell erforderlich werdende Demontage des Funktionsabschnitts sehr erschwert oder sogar nur unter Zerstörung der Leiterfolie möglich.

Der in der Figur 2 dargestellte Aufbau des elektronischen Geräts 1 ermöglicht ein zwischenraumfreies Anpressen des Funktionsabschnitts 3 an die Rückseite der Bedienblende 4. Erfindungsgemäß ist dazu vorgesehen, zwischen dem Gehäuse 10 und dem Funktionsabschnitt 3 der Leiterfolie 2 sowohl einen leistenförmigen Körper aus einen elastomeren Material, im Folgenden kurz als Elastomerkörper 6 bezeichnet, als auch einen leistenförmigen Körper aus ein nichtelastomeren Material, im Folgenden kurz als Leiste 7 benannt, anzuordnen.

Der Elastomerkörper 6 kann im Unterschied zu der in Zeichnung dargestellten Ausführung grundsätzlich auch mehrteilig ausgeführt sein, beispielsweise durch mehrere nebeneinander angeordnete Leistenteile mit einer jeweils kürzeren Längserstreckung. Zur Vereinfachung der Beschreibung wird der Elastomerkörper 6 hier aber, ohne Beschränkung der Allgemeinheit, ausschließlich in einer einteiligen Ausführung erläutert.

Die aus einem nicht elastomeren Material bestehende Leiste 7 wird durch seitlich angeformte Rastelemente 14 mit dem Gehäuse 10 verbunden und hält dadurch auch den Elastomerkörper 6 am Gehäuse 10, der seitlich durch einen am Gehäuse 10 angeformten Befestigungskragen 12 umschlossen wird.

Der Elastomerkörper 6 wird durch die Befestigung des Geräts 1 an der Bedienblende 4 komprimiert und erzeugt eine Andruckkraft, die über die Leiste 7 auf den Funktionsabschnitt 3 der Leiterfolie 2 wirkt. Die Leiste 7 erfüllt hierbei die zusätzliche Funktion, den Funktionsabschnitt 3 zu versteifen und dadurch zu stabilisieren. Zu diesem Zweck kann der Funktionsabschnitt 3 auch auf die Leiste 7 aufgeklebt sein.

Um ihre Form gut an die Bedienblende 4 anpassen zu können, ist die Leiste 7 zwar aus einem festen und unelastischen Material gefertigt, aber relativ dünn ausgebildet, so dass die Leiste 7 insgesamt über ihre Länge biegsam ist. Vorteilhafterweise weist die Leiste 7 eine Kammstruktur auf, die durch entlang der Leiste 7 in Querrichtung eingebrachte Einschnitte 9 entsteht. Diese Einschnitte 9 unterteilen die Leiste 7 in eine Vielzahl miteinander zusammenhängender Lamellen 13, die jeweils ein Stück weit gegeneinander auslenkbar sind und die eine gute Anpassung die Form der Leiste 7 und damit auch des mit der Leiste verbundenen Funktionsabschnitts 3 an den, möglicherweise unebenen oder gewölbten Formverlauf der Bedienblende 4 ermöglicht.

Die Strukturierung der Leiste 7, insbesondere die Anzahl der durch eingebrachte Einschnitte 9 gebildeten Lamellen 13 kann entsprechend der Form der vorgesehenen Bedienblende 4 ausgestaltet werden. Eine besonders unebene oder stark gewölbte Fläche der Bedienblende 4 kann so durch eine ausreichend groß gewählte Anzahl von Lamellen 13 beziehungsweise von in die Leiste 7 eingebrachten Einschnitten 9 ausgeglichen werden.

Der Elastomerkörper 6 passt sich über seine Länge den gegebenenfalls unterschiedlichen Auslenkungen der Lamellen 13 an und sorgt so für eine dichte Anpressung des an der Leiste 7 anliegenden Funktionsabschnitts 3 an die Bedienblende 4.

Die Verwendung der Leiste 7 ist zudem deshalb vorteilhaft, da die Leiterfolie 2 an der Leiste 7 mit relativ einfachen Mitteln, insbesondere durch Ankleben vormontierbar ist. Dagegen wäre eine Befestigung des Funktionsabschnitts 3 an dem Elastomerkörper 6 nicht oder nur mit einem erheblich größeren Aufwand möglich.

Dies gilt besonders dann, wenn der Elastomerkörper 6 keine kompakte Struktur ausbildet, sondern eine Vielzahl von Ausnehmungen 11 aufweist, durch die hindurch der Funktionsabschnitt 3 der Leiterfolie 2 und Teile der Bedienblende 4 durch im Gehäuse 10 angeordnete Leuchtmittel hinterleuchtet werden kann. Der Elastomerkörper 6 kann dadurch eine etwa wabenartige Struktur aufweisen. Um eine Hinterleuchtung der Bedienblende 4 zu ermöglichen, sind die Leiste 7 und zumindest Teile des Funktionsabschnitts 3 transparent ausgeführt. Dem entsprechend ist auch die Bedienblende 4 vorzugsweise transparent oder teiltransparent ausgebildet.

### Bezugszeichen

- 1: Gerät
- 2: Leiterfolie
- 3: Funktionsabschnitt (Teilfläche der Leiterfolie 2)
- 4: Bedienblende
- 5: Außenseite (des Gehäuses)
- 6: Elastomerkörper
- 7: Leiste
- 8: funktionalen Berührfläche
- 9: Einschnitte
- 10: Gehäuse
- 11: Ausnehmungen
- 12: Befestigungskragen
- 13: Lamellen
- 14: Rastelemente
- 15: Stirnfläche (des Geräts)

## Patentansprüche

1. Elektronisches Gerät (1)
mit einem Gehäuse (10) und mit einer mit dem Gehäuse (10) elektrisch verbundenen Leiterfolie (2),
wobei die Leiterfolie (2) einen Funktionsabschnitt (3) aufweist, der sich außerhalb des Gehäuses (10) befindet, und der Sensoren und/oder Anzeigeelemente trägt und zur Montage an der Rückseite einer Bedienblende (4) vorgesehen ist,
**dadurch gekennzeichnet,**
**dass** zwischen einer Außenseite (5) des Gehäuses (10) und der Rückseite des Funktionsabschnitts (3) ein Elastomerkörper (6) und eine Leiste (7) aus einem nichtelastomeren Kunststoff angeordnet sind,
**dass** die Außenseite (5) des Gehäuses (10) und die Hauptflächen des Elastomerkörpers (6) und der Leiste (7) im Wesentlichen parallel zueinander angeordnet sind, und
**dass** die mit dem Gehäuse (10) verbundene Leiste (7) den Elastomerkörper (6) klemmend oder formschlüssig am Gehäuse (10) befestigt.

2. Elektronisches Gerät nach Anspruch 1, **dadurch gekennzeichnet, dass** die Außenseite (5) des Gehäuses (10), der Elastomerkörper (6) und die Leiste (7) annähernd gleich große Längen und Breiten aufweisen.

3. Elektronisches Gerät nach Anspruch 1, **dadurch gekennzeichnet, dass** die Leiste (7) mehrere senkrecht zu ihrer Längserstreckung eingebrachte Einschnitte (9) aufweist.

4. Elektronisches Gerät nach Anspruch 1, **dadurch gekennzeichnet, dass** die Leiste (7) an ihren Endabschnitten mit dem Gehäuse (10) verbindbare Rastelemente (14) aufweist.

5. Elektronisches Gerät nach Anspruch 1, **dadurch gekennzeichnet, dass** der Elastomerkörper (6) eine Wabenstruktur mit mehreren Ausnehmungen (11) aufweist.

6. Elektronisches Gerät nach Anspruch 1, **dadurch gekennzeichnet, dass** die Leiste (7) aus einem transparenten Material besteht.

7. Elektronisches Gerät nach Anspruch 1, **dadurch gekennzeichnet, dass** der Funktionsabschnitt (3) kapazitive Sensorelemente trägt.

8. Bedienanordnung mit einem elektronischen Gerät (1) nach Anspruch 1, **dadurch gekennzeichnet, dass** eine Seite des Funktionsabschnitts (3) an der Rückseite der Bedienblende (4) anliegt.

9. Bedienanordnung mit einem elektronischen Gerät (1) nach Anspruch 8, **dadurch gekennzeichnet, dass** die Bedienblende (4) ein Teil des Armaturenbretts eines Kraftfahrzeugs ist.

10. Bedienanordnung mit einem elektronischen Gerät (1) nach Anspruch 8, **dadurch gekennzeichnet, dass** die Bedienanordnung ein Teil eines Haushaltsgeräts ist.

## Claims

1. An electronic device (1)
with a housing (10) and a flexible printed circuit board foil (2) connected electrically to the housing (10),
whereby the flexible printed circuit board foil (2) has a functional section (3) which is outside the housing (10) and which carries sensors and/or display elements and is designed to be assembled to the rear side of an operating panel (4)
**characterised by the fact that**
an elastomer body (6) and a strip (7) in a non-elastomeric plastic are fitted between the exterior (5) of the housing (10) and the rear side of the functional section (3),
the exterior (5) of the housing (10) and the main surfaces of the elastomer body (6) and the strip (7) are principally located parallel to each other and
the strip (7) attached to the housing (10) fixes the elastomer body (6) to the housing (10) by clamping or as a complete fit

2. An electronic device as in Claim 1, **characterised by** the fact that the exterior (5) of the housing (10), the elastomer body (6) and the strip (7) are more or less equal in length and width.

3. An electronic device as in Claim 1, **characterised by** the fact that the strip (7) has several cut-outs (9) vertical to its length.

4. An electronic device as in Claim 1, **characterised by** the fact that, at its end-sections, the strip (7) has latching elements (14) which can be attached to the housing (10).

5. An electronic device as in Claim 1, **characterised by** the fact that the elastomer body (6) has a honeycomb structure with several recesses (11).

6. An electronic device as in Claim 1, **characterised by** the fact that the strip (7) is made of a transparent material.

7. An electronic device as in Claim 1, **characterised by** the fact that the functional section (3) carries capacitive sensor elements.

8. An operating arrangement with an electronic device (1) as in Claim 1, **characterised by** the fact that one side of the functional section (3) lies against the rear side of the operating panel (4).

9. An operating arrangement with an electronic device (1) as in Claim 8, **characterised by** the fact that the operating panel (4) is part of the instrument panel of a motor vehicle.

10. An operating arrangement with an electronic device (1) as in Claim 8, **characterised by** the fact that the operating panel (4) is part of a domestic appliance.

## Revendications

1. Appareil électronique (1) avec un boîtier (10) et une feuille conductrice (2) qui est reliée électriquement au boîtier (10),
sachant que la feuille conductrice (2) présente une section fonctionnelle (3) qui est située en dehors du boîtier (10) et porte des capteurs et / ou des éléments d'affichage et qui est prévue pour le montage sur face arrière d'un écran de commande (4),
**caractérisé en ce que**,
entre un côté extérieur (5) du boîtier (10) et le côté arrière de la section fonctionnelle (3), sont disposés un corps élastomère (6) et une barre (7) en matière synthétique non élastomère,
le côté extérieur (5) du boîtier (10) et les surfaces principales du corps élastomère (6) et de la barre (7) sont essentiellement disposés parallèlement les uns par rapport aux autres.
la barre (7) reliée au boîtier (10) fixe le corps élastomère (6) sur le boîtier (10) par coincement ou par emboîtement.

2. Appareil électronique selon la revendication 1, **caractérisé en ce que** le côté extérieur (5) du boîtier (10), le corps élastomère (6) et la barre (7) présentent des longueurs et largeurs approximativement semblables.

3. Appareil électronique selon la revendication 1, **caractérisé en ce que** la barre (7) présente plusieurs incisions (9) pratiquées verticalement par rapport au sens de sa longueur.

4. Appareil électronique selon la revendication 1, **caractérisé en ce que** la barre (7) présente, à ses extrémités, des éléments d'arrêt (14) qui peuvent être reliés au boîtier (10).

5. Appareil électronique selon la revendication 1, **caractérisé en ce que** le corps élastomère (6) présente une structure alvéolée avec plusieurs évidements (11).

6. Appareil électronique selon la revendication 1, **caractérisé en ce que** la barre (7) consiste en une matière transparente.

7. Appareil électronique selon la revendication 1, **caractérisé en ce que** la section fonctionnelle (3) porte des capteurs capacitifs.

8. Ensemble de commande avec un appareil électronique (1) selon la revendication 1, **caractérisé en ce qu'**un côté de la section fonctionnelle (3) porte contra la face arrière de l'écran de commande (4).

9. Ensemble de commande avec un appareil électronique (1) selon la revendication 8, **caractérisé en ce que** l'écran de commande (4) fait partie du tableau de bord d'un véhicule automobile.

10. Ensemble de commande avec un appareil électronique (1) selon la revendication 8, **caractérisé en ce que** l'ensemble de commande fait partie d'un appareil ménager.
